Europäisches Patentamt

European Patent Office

Office européen des brevets

(11) Veröffentlichungsnummer: **0 000 883**
**B1**

(12) **EUROPÄISCHE PATENTSCHRIFT**

(21) Anmeldenummer: **78100594.7**

(22) Anmeldetag: **04.08.78**

(51) Int. Cl³: **H 01 L 29/10,**
**H 01 L 29/78**

(54) Isolierschicht-Feldeffektransistor

(30) Priorität: **31.08.77 US 829393**

(43) Veröffentlichungstag der Anmeldung:
**07.03.79 Patentblatt 79/05**

(45) Bekanntmachung des Hinweises auf die Patenterteilung:
**28.05.80 Patentblatt 80/11**

(84) Benannte Vertragsstaaten: **DE FR GB**

(56) Entgegenhaltungen:
**US - A - 3 283 221**
**US - A - 4 021 835**

(73) Patentinhaber: **International Business Machines Corporation**
**Armonk, N.Y. 10504 (US)**

(72) Erfinder: **Beilstein, Kenneth Edward, Jr.**
**11619 Smithfield Rd.**
**Manassas VA 22110 (US)**
**Kotecha, Harish Narandas**
**8858 Cherry Oak Ct.**
**Manassas VA 22110 (US)**

(74) Vertreter: **Böhmer, Hans Erich, Dipl.-Ing.**
**Schönaicher Strass 220**
**D-7030 Böblingen (DE)**

Courier Press, Leamington Spa, England.

# Isolierschicht-Feldeffekttransistor

Die Erfindung betrifft einen Isolierschicht-Feldeffekttransistor mit einem zwischen Source- und Drainzone eines ersten Leitungstyps gebildeten Kanal eines zweiten Leitungstyps in einem Substrat des zweiten Leitungstyps und einer über dem Kanal liegenden isolierten Gate-Elektrode. Ein derartiger Isolierschicht-Feldeffekttransistor ist aus der US - A - 4021 835 bekannt.

Der Wirkungsgrad der meisten aus MOSFETs aufgebauten logischen Schaltungen hängt davon ab, wie gut sie sich für die Stromsteuerung eignen. Die Stromsteuerung hängt dabei wiederum von der Schwellenwertspannung ab, die eine Funktion der Spannungsdifferenz zwischen Source-Elektrode und Substrat ist. Da bei bestimmten Schaltungsanwendungen mit ungeerdeten Source-Elektroden die Sourcespannung schwankt, schwankt damit auch die zwischen Source und Substrat liegende Spannung. Daher verändert sich auch die Schwellenwertspannung, so daß die mit dem Transistor erzeugte Stromsteuerung sich ändert. Das Problem besteht darin, die Empfindlichkeit der Schwellenwertspannung gegenüber Veränderungen der zwischen Source und Substrat liegenden Spannung zu verringern. Die Änderungsgeschwindigkeit der Schwellenwertspannung in bezug auf die zwischen Source und Substrat liegende Spannung wird allgemein als die Substratempfindlichkeit des Feldeffekttransistors bezeichnet. Die Substratempfindlichkeit ist eine Funktion verschiedener Faktoren, wie zum Beispiel die Dicke der Oxidschicht, die Dotierung des Substrats, die Dielektrizitätskonstante usw. Man hat sich daher das Ziel gesetzt, die Schwankungen der Schwellenwertspannung während des Betriebs dadurch zu verringern, daß man die Substratempfindlichkeit verringert, wodurch sich eine verbesserte Stromsteuerung ergibt.

Man hat im Stand der Technik schon vielfach versucht, die Substratempfindlichkeit zu verbessern. Man hat beispielsweise vorgeschlagen, Substrate mit hohem spezifischem Widerstand in der Weise zu erzielen, daß man gleichförmig die Dotierungskonzentration des Substrats änderte, weil man geglaubt hat, damit auch eine bessere Kapazität zu erreichen. Wenn man jedoch Substrat mit höherem spezifischem Widerstand verwendet, dann treten bei hoher Packungsdichte Schwierigkeiten auf, wie z. B. Kanalkurzschlüsse, und ähnliches. Wenn die gesamte Hintergrundleitfähigkeit verringert wird, können sich in den Feldbereichen Inversionen einstellen, so daß die Schaltung nicht richtig arbeitet. Obwohl sich einige Vorteile durch Verwendung von Substraten mit hohem spezifischem Widerstand erzielen lassen, wird doch ein beträchtlicher Teil des so erzielten Gewinns durch die dabei auftretenden Schwierigkeiten wieder zunichte gemacht.

Ein anderer Versuch zur Erzielung einer niedrigen Substratempfindlichkeit besteht in einer Substratisolation, in dem man das Substrat für jeden Transistor isoliert. Die Herstellungskosten werden dabei außerordentlich hoch, da für diese doppelte Diffusion und die Dotierung von zwei verschiedenen Zonen komplexe Verfahren eingesetzt werden müssen. Außerdem ergibt sich dabei eine geringere Packungsdichte, weil jeder Transistor für sich isoliert werden muß.

Aus der US—A—4 021 835 ist es bekannt, bei einem Isolierschicht-Feldeffekttransistor eine unter einem Kanal zwischen Source- und Drainzone liegende dotierte Schicht durch Ionenimplantation herzustellen.

Es ist ferner an sich bekannt, in der Kanalzone eines FET eine doppelte Ionenimplantation durchzuführen, wodurch ein implantierter Übergang vom Verarmungstyp in Richtung auf die Oberfläche des Kanals verschoben wird, um das Problem eines Transistors vom Verarmungstyp zu lösen, der sich sonst nicht steuern oder abschalten läßt. Dies wird durch doppelte Ionenimplantation von Materialien entgegenesetzen Leitungstyps erzielt, die einen plötzlichen Übergang liefern. Es ist jedoch nicht so, daß sich durch einfache Ionenimplantation die erwünschte Verringerung der Substratempfindlichkeit zwangsläufig ergibt.

*Aufgabe der Erfindung*

Es ist somit Aufgabe der Erfindung, die Empfindlichkeit der Schwellenwertspannung eines MOSFET gegenüber Veränderungen der zwischen Source und Substrat liegenden Spannung zu verringern.

*Gesamtdarstellung der Erfindung*

Diese der Erfindung zugrunde liegende Aufgabe wird durch die Struktur eines Isolierschicht-Feldeffekttransistors der eingangs genannten Art gelöst, die sich dadurch auszeichnet, daß in dem Substrat unterhalb des Kanals zwischen Source- und Drainzone eine vergrabene Isolierschicht vorgesehen ist, die im Falle eines durch Anlegen einer kritischen Substrat-Source-Vorspannung $V_{xsc}$ vollständig verarmten Kanals vorhandene effektive Verarmungszone des Transistors tiefer in das Substrat hinein ausdehnt, so daß der Abstand zwischen den elektrostatischen Ladungen auf der Gate-Elektrode und den von ihnen im Substrat induzierten Ladungen derart erhöht ist, daß die Empfindlichkeit der Schwellenwertspannung $V_T$ gegenüber Änderungen der Substrat-Source-Vorspannung $V_{xs}$ verringert ist. Vorzugsweise ist die Anordnung dabei so getroffen, daß die Isolierschicht eine dotierte Isolierschicht des ersten Leitungstyps ist, bei der sich die Verarmungszonen des von der Isolierschicht mit dem Substrat gebildeten unteren und des von der Isolierschicht mit dem Kanal gebildeten oberen

**0 000 883**

P—N—Übergangs etwa in der Mitte der Isoliershicht miteinander vereinigen und somit ein zusammenhängendes verarmtes Gebiet bilden.

Die Erfindung wird nunmehr anhand von Ausführungsbeispielen in Verbindung mit den beigefügten Zeichnungen im einzelnen beschrieben.

In den Zeichnungen zeigt

Fig. 1A eine Querschnittsansicht einer erfindungsgemäß aufgebauten Struktur und

Fig. 1B das zugehörige Dotierungsprofil längs der Schnittlinie X—X' von Fig. 1A, jedoch um 90° gedreht,

Fig. 2 das Dotierungsprofil der Fig. 1B zur Darstellung der Veraramungszonen,

Fig. 3 eine graphische Darstellung der Substratempfindlichkeit in Millivolt je Volt als Funktion der Implantierungs-Dosierung für verschiedene Implantierungsenergien für den erfindungsgemäß ausgestalteten Feldeffekttransistor,

Fig. 4 ein Diagramm zur Darstellung der Schwellenwertspannung $V_T$ als Funktion der zwischen Source und Substrat liegenden Spannung $|V_{sx}|$ gemäß dem Stand der Technik und der Erfindung.

Fig. 5 eine graphische Darstellung der Beziehung zwischen der Substratempfindlichkeit in Millivolt je Volt als Funktion der zwischen Source und Substrat liegenden Spannung $|V_{sx}|$ gemäß dem Stand der Tecknik und nach der Erfindung,

Fig. 6A verallgemeinert eine MOSFET-Inverterstufe und

Fig. 6B ein Diagramm zur Darstellung des normalisierten Drain-Source-Stromes und der Ausgangsspannung unter Verwendung eines MOSFET gemäß Fig. 6A zur Darstellung der durch die Erfindung verbesserten Stromsteuerung.

Die elektrostatische Wechselwirkung zwischen dem Substrat und der Gate-Elektrode eines FET kann dadurch verringert werden, daß man eine Isolierschicht vorbestimmter Dicke und Tiefe unterhalb der Oberfläche des Substrats unterhalb des Kanals anbringt, so daß der Abstand zwischen der Gate-Elektrode und den innerhalb des Substrats befindlichen elektrostatischen Ladungen, die zu den tatsächlich auf der Gate-Elektrode liegenden Ladungen spiegelbildlich auftreten, effektiv erhöht wird. Da die Potentialdifferenz zwischen der Gate-Elektrode und den spiegelbildlichen Ladungen im Inneren des Substrats der elektrostatischen Feldstärke, multipliziert mit dem dazwischen liegenden Abstand, direkt proportional ist, wird bei gleicher Feldstärke, dann, wenn der Abstand vergrößert wird, auch die Potentialdifferenz erhöht. Wird der Gate-Elektrode eine Einheitsladung mehr zugeführt, nimmt die insgesamt innerhalb des Substrats zur Aufrechterhaltung des Ladungsgleichgewichts erforderliche Potentialerhöhung mit zunehmender Dicket der Isolierschicht zu. Man sieht daher, daß der Einfluß auf das Gate-Potential, welcher sich aus Veränderungen des Substrat-Potentials ergeben, d. h. die elektrostatische Wechselwirkung sich verringert, wenn der Abstand zwischen den spiegelbildlichen Ladungen dadurch erhöht wird, daß man eine vergrabene Isolierschicht einfügt.

Wenn an der Gate-Elektrode ein so hohes Potential liegt, daß ein Strom zwischen Source und Drain zu fließen beginnt, d. h. daß die Gatespannung der Schwellenwertsppannung entspricht, dann wird eine gegebene Größe einer Spannungsveränderung in der zwischen Source und Substrat herrschenden Spannung dann eine geringere Einwirkung auf die Stromleitung im Kanalbereich haben, wenn die dazwischen liegende Isolierschicht dicker ist, d. h. wenn ein größerer Abstand zwischen den spiegelbildlich induzierten Ladungen im Inneren des Substrats und in der Gate-Elektrode vorhanden ist. Wenn man daher eine Isolierschicht einer vorgegebenen Dicke in einer gewünschten Tiefe unterhalb der Oberfläche des Substrats im Kanalbereich einführt, dann wird die Einwirkung von Veränderungen im Substratpotential auf die Schwellenwertspannung herabgesetzt.

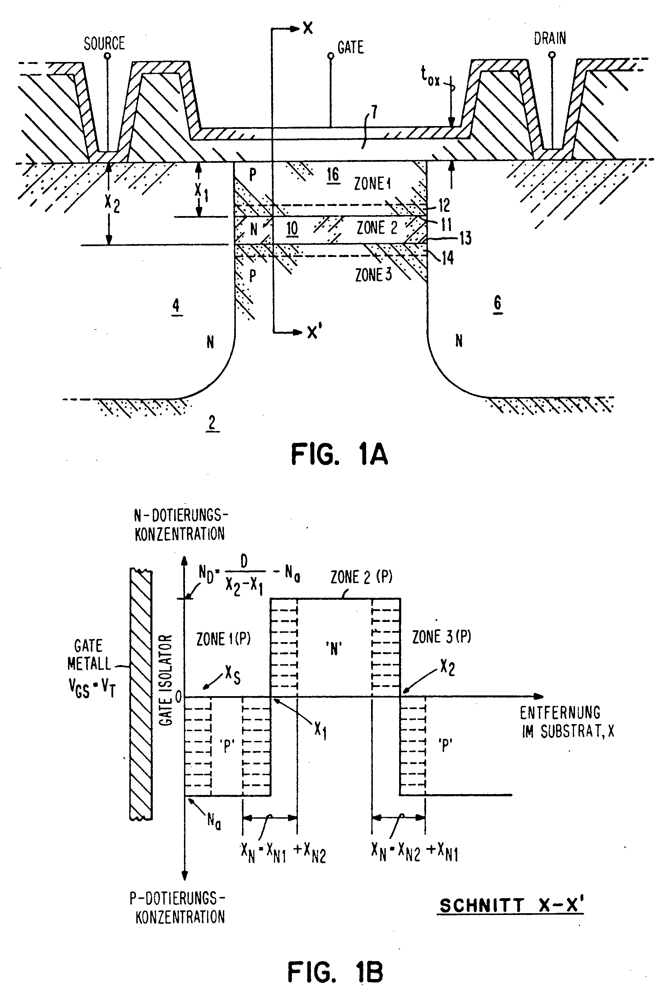

Das bevorzugte Verfahren zum Einführen einer Isolierschicht besteht durch Ionen-Implantation einer dotierten Isolierschicht 10 des gleichen einen N-Leitungstyp hervorrufenden Dotierungsmaterials wie bei Source und Drain, mit einer vorbestimmten Tiefe von $X_1$—$X_2$ unterhalb der Substratoberfläche im Kanalbereich in Fig. 1A. Dadurch erhält man zwei P—N—Übergänge, nämlich einen oberen P—N—Übergang 11 und einen unteren P—N—Übergang 13 mit dem umgebenden P—N—Übergängen bildet sich im Übergangsbereich eine Verarmungszone. Die Dicke und die Konzentration der implantierten Isolierschicht 10 wird dabei vorzugsweise so gewählt, daß die Verarmungszone 12 für den oberen P—N—Übergang und die Verarmungszone 14 für den unteren P—N—Ubergang 13 soweit aneinanderrücken, daß die dazwischenliegende Schicht praktisch eine Isolierschicht ist. Daher läßt sich eine vergrabene Isolierschicht 10, die zur Verringerung der Empfindlichkeit der Schwellenwertspannung gegenüber der Substratspannung erwünscht ist, durch Ionen-Implantation von einer Schicht mit der gleichen Leitfähigkeit wie Source- und Drainzone in dem Kanalbereich erzielen.

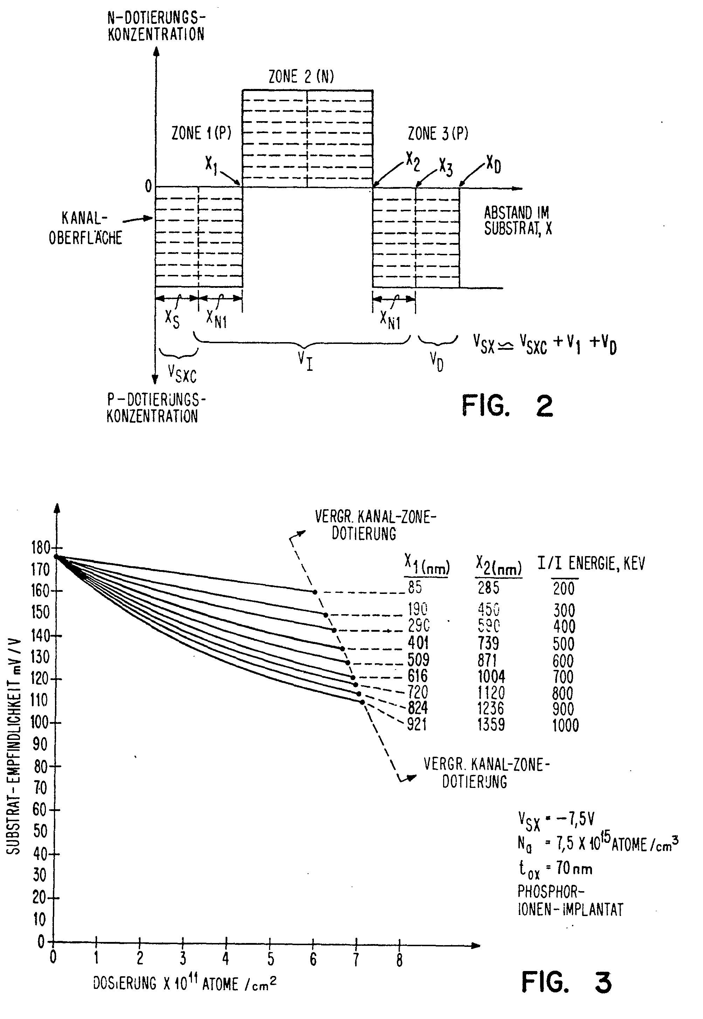

Es sei darauf verwiesen, daß bei zu hoher Konzentration der vergrabenen dotierten Isolierschicht 10 in bezug auf die Konzentration der Hintergrunddotierung für das Substrat 2 ein elektrischer Kurzschluß zwischen Sourcezone 4 und Drainzone 6 eintreten kann. Ist dagegen die Konzentration der vergrabenen dotierten Isolierschicht 10 zu niedrig, so erhält man nur einen verschwindend kleinen Einfluß auf die Empfindlichkeit der Schwellwertspannung in bezug auf die zwischen Source und Substrat liegende Spannung. Es wurde festgestellt, daß es dabei kritische Werte für die Tiefe $X_1$ der dotierten Isolierschicht 10 unterhalb der Oberfläche des Substrats 2, die Dicke $(X_2—X_1)$ der dotierten Isolierschicht 10 und deren Konzentration gibt, innerhalb derer man einen Bereich verringerter Empfindlichkeiten der Schwellenwertspannung in bezug auf die zwischen Source und Substrat anliegende Spannung erhält. Einige Beispiele dieser Kombination von Tiefe, Dicke und Konzentration für die vergrabene dotierte Isolierschicht 10 sind in Fig. 3 dargestellt.

Im folgenden soll eine Analyse der Schwellenwertgleichungen mit den notwendigen Randbedingungen für einen N-Kanal-MOSFET für eine verbesserte Substratempfindlichkeit gegeben werden. Für diese Analyse soll die Gauss'sche Verteilung für eine tiefe Ionen-Implantation für eine rechteckige Verteilung normalisiert werden, deren Breite 2—1/2mal der Standardabweichung der Ausbreitung des Ionen-Implantats entspricht, während die Dosierung D die Spitzendosierung ist. Diese Annäherung der Gauss'schen Verteilung wird dabei so durchgeführt, daß dabei die Implantationsdosierung erhalten bleibt. Obgleich diese Analyse für N-Kanal-MOSFETS durchgeführt wird, gilt sie mit den entsprechenden Polaritätsänderungen in gleicher Weise für P-Kanal-MOSFETS.

Fig. 1B ist eine zusammengesetzte Teilfigur, die das Dotierungsprofil über dem Kanalbereich der Fig. 1A von der Gate-Isolierschicht 7 nach unten bis in as Innere des Halbleitersubstrats 2 zeigt. $N_a$ ist die Dotierungskonzentration des Halbleitersubstrats 2. Für den Beginn der Analyse in der Zone 1 (vergleiche auch Fig. 1A) sei angenommen, daß die Gate-Source-Vorspannung $V_{GS}$ gleich der Schwellenwertspannung $V_T$ sei und daß die Substrat-Source-Vorspannung $V_{SX}$ so gewählt sei, daß die Kanalverarmungsschicht unmittelbar unterhalb der Gate-Isolierschicht in der Zone 1 sich nicht mit der Verarmungszone 12 vereinigt. Ferner sei angenommen, daß die Implantationsbegindungen so gewählt sind, daß die Verarmungszonen 12 und 14 nicht ineinander fließen und daß daher die vergrabene Isolierschicht 10, die auch als Zone 2 bezeichnet sei, die Sourcezone 4 und dia Drainzone 6 kurzschließt. Mit diesem Ausgangspunkt soll zunächst die Bedingung für die nicht-leitende oder verarmte Zone 2 entwickelt werden.

Anschließend wird ein Ausdruck für die kritische Substrat-Source-Vorspannung $V_{sxz}$ abgeleitet, wobei bei Uberschreiten dieser Größe der Bereich 16 des Substrats 2 (auch als Zone 1 bezeichnet) vollständig verarmt, so daß man zusammen mit der Zone 2 einen Feldeffekttransistor mit verbesserter Substratempfindlichkeit erhält. Ist die Substrat-Vorspannung $V_{sx}$ kleiner als dieser kritische Wert und ist die Zone 2 verarmt, dann hat der Transistor eine mit dem Stand der Technik vergleichbare Substratempfindlichkeit.

Aus Symmetrie-Bedingungen sind in der Zone 2 die Breiten $X_N$ der Verarmungszonen 12 und 14 zu beiden Seiten die gleichen. Soll in der Zone 2 eine Verarmung hergestellt werden, dann gilt für den in die Zone 2 fallenden Teil der Breite einer Verarmungszone $X_{N2}$:

$$2X_{N2} \geqslant X_2 - X_1 \tag{1}$$

Da unter dieser Bedingung die beiden P—N-ubergänge 11 und 13 der Zone 2 auf gleichem Potential liegen, werden die Verarmungszonen 12 und 14 nur durch die innere Spannung über den P—N-übergangen aufrechterhalten. Es ist aus der Theorie der stufenförmigen Übergänge bekannt, daß

$$2X_N = 2\sqrt{\frac{2\,\epsilon_O\,\epsilon_S\,N_a\,V_J}{q(N_a + N_D)\,N_D}} \tag{2}$$

wobei

$N_D$ die Konzentration der implantierten Ionen
$\epsilon_O$ die Dielektrizitätskonstante des freien Raumes,
$\epsilon_S$ die Dielektrizitätskonstante des Halbleitermaterials und
q die Ladung des Elektrons
$V_J$ die innere Spannung über der Verarmungszone 12 oder 14 ist.
Für eine vollständige Verarmung der Zone 2 gilt die Gleichung

$$X_2 - X_1 \leqslant 2\sqrt{\frac{2\,\epsilon_O\,\epsilon_S\,N_a\,V_J}{q(N_a + N_D)\,N_D}} \tag{3}$$

$V_J$ verhält sich zu $(X_2 - X_1)$ gemäß dem folgenden Ausdruck, den man aus jedem beliebigen Lehrbuch über Halbleiterphysik und auch aus Gleichung 3 ableiten kann.

$$V_J = \frac{kT}{q}\,\ln\,\frac{N_a N_D}{n_i^2} = \frac{kT}{q}\,\ln\left[\frac{N_a}{n_i^2}\left(\frac{D}{X_2 - X_1} - N_a\right)\right] \tag{4}$$

wobei

k die Boltzmann-Konstante,
T die Temperatur und
$n_i$ die Eigen-Trägerkonzentration des Halbleiter materials ist.

4

Man sieht, daß $V_J$ sich langsam mit Bezug auf $(X_2 - X_1)$ ändert und daher durch Annahme eines Näherungswertes für $(X_2 - X_1)$ bestimmt werden kann.

Bei einer vollständigen Verarmung der Zone 1 gilt für die Breite $X_S$ der Kanal verarmungsschicht unterhalb der Gute-Isoliershicht:

$$X_S \geqslant (X_1 - X_N) \qquad (5)$$

mit

$$X_S = \frac{2 \epsilon_O \epsilon_s (|V_{sxc}| + 2\phi)}{qN_a} \text{ bei } X_S = (X_1 - X_{N1})$$

wobei

$\phi =$ das Fermi-Potential des Halbleitersubstrats und

$X_{N1} =$ die Breite des indie Zone 1 fallenden Teils einer Verarmungszone ist. Da die Zone 2 ebenfalls verarmt ist, ergibt sich aus der Ladungs-Neutralitätsüberlegung

$$N_a X_{N1} = N_D \frac{(X_2 - X_1)}{2} \qquad (6)$$

die man für $|V_{sxc}|$ aus den obigen drei Ausdrücken löst:

$$|V_{sxc}| = \frac{qN_a}{8\epsilon_O \epsilon_s} \left( (X_2 + X_1) - \frac{D}{N_a} \right)^2 - 2\phi \qquad (7)$$

Fig. 2 zeigt im wesentlichen die Einzelheiten der Fig. 1B, wenn die Zonen 1, 2 und 3 verarmt sind. $V_{sxc}$, $V_i$ und $V_D$ sind dabei die über den verarmten Zonen 1, 2 und 3 liegenden Spannungen, so daß deren Gesamtsumme etwa gleich der Substrat-Source-Vorspannung $V_{sx}$ ist.

Damit ist die Analyse zur Bestimmung der kritischen Bedingungen für die Verarmung abgeschlossen. Anschliessend sollen die verschiedenen Spannungsausdrücke, die die Substratvorspannung bilden und zu einem Ausdruck für die verbesserte Substratempfindlichkeit führen, abgeleitet werden.

Aus der Beziehung zwischen $X_s$ und $|V_{sxc}|$ erhält man den Spannungsabfall über $X_s$ in der Zone 1, auf die in $X_s$ liegenden Ladungen zu:

$$|V_{sxc}| = \frac{qN_a}{2\epsilon_O \epsilon_s} X_s^2 - 2\phi \qquad (8)$$

Das elektrische Feld E in den Verarmungszonen in Fig. 2 (vergleiche auch Fig. 1A) von der Kanaloberfläche nach $X_3$, das über das innere Feld hinausgeht, steht durch das Gauss'sche Gesetz zu den in der Zone $(X_D - X_3)$ in Fig. 2 befindlichen Ladungen in Beziehung durch:

$$E = \frac{(X_D - X_3) qN_a}{\epsilon_O \epsilon_s} \qquad (9)$$

Dadurch erhält man die auf die Ladungen zwischen $X_3$ und $X_D$ in Zone 3 zurückzuführende Spannung:

$$|V_I| = EX_3 = \frac{(X_D - X_3) X_3}{\epsilon_O \epsilon_s} qN_a \qquad (10)$$

Die Verarmungszone $(X_D - X_3)$ wird jedoch durch die Spannung $V_D$ verursacht, so daß

$$|V_D| = \frac{(X_D - X_3)^2 qN_a}{2\epsilon_O \epsilon_s} \qquad (11)$$

wird.

Als Schwellenwertbedingung sieht man, daß

$$V_T = V_{FB} + 2\phi + q\frac{N_a}{C_{ox}} (X_s + X_D - X_3) \text{ ist,} \qquad (12)$$

wobei

$V_{FB}$ die Flachbandspannung des Transistors und

$C_{ox}$ die Gate-Isolierkapazität je Flächeneinheit ist.

Wandelt man den oben genannten Ausdruck um und verwendet dabei die Annäherung:

$$V_{sx} \approx V_{sxc} + V_I + V_D \qquad (13)$$

dann ist der Ausdruck für die Schwellenwertspannung gegeben durch:

$$V_T = V_{FB} + 2\phi + q\frac{N_a}{C_{ox}} \left[ -\frac{D}{N_a} + \sqrt{\frac{2\epsilon_O \epsilon_s}{qN_a}(V_{sx} + 2\phi) + (X_1 + X_2)\frac{D}{N_a}} \right] \qquad (14)$$

für

$$(X_2 - X_1) \le 2\sqrt{\frac{2\epsilon_O \epsilon_s N_a V_J}{q(N_a + N_D)N_D}} \qquad (15)$$

und

$$V_{sx} \ge V_{sxc} = q\frac{N_a}{8\epsilon_O \epsilon_s} \left[ (X_2 + X_1) - \frac{D}{N_a} \right]^2 - 2\phi \qquad (16)$$

Es sei darauf hingewiesen, daß in Gleichung 14, wenn $D = 0$ ist,

$$V_T = V_{FB} + 2\phi + \frac{1}{C_{ox}}\sqrt{2q\epsilon_O \epsilon_s N_a(V_{sx} + 2\phi)} \qquad (17)$$

wird. Das ist aber die klassische Schwellenwertspannungsgleichung, die man in jedem Handbuch über Halbleiterphysik finden kann.

Soll ein Transistor vom Verarmungstyp gebildet werden, dann kann eine weitere flache Ionen-Implantation geeigneter Dosierung und Energie zur Verschiebung der Schwellenwertspannung um den Betrag $V_{Dosierung}$ verwendet werden. Da es sich hierbei um eine sehr flache Implantation handelt, wird dadurch die durch die tiefe Implantation erzielte Verbesserung der Substratempfindlichkeit nicht beeinflußt.

Die Substratempfindlichkeit der Halbleitervorrichtung ist gegeben durch die Differentiation der Gleichung 14:

$$\frac{dV_T}{dV_{sx}} = \frac{\epsilon_O \epsilon_s}{C_{ox}\sqrt{\frac{2\epsilon_O \epsilon_s}{qN_a}(V_{sx} + 2\phi) + (X_1 + X_2)\frac{D}{N_a}}} \qquad (18)$$

Diese Gleichung 18 stellt die kritische Beziehung zwischen der Dosierung D, dem oberen Grenzwert $X_1$ und dem unteren Grenzwert $X_2$ für die vergrabene Isolierschicht 10 im Substrat 2 der Fig. 1A dar, das eine Dotierkonzentration $N_a$ zur Erzielung der gewünschten Empfindlichkeit der Schwellenwertspannung $dV_T/dV_{sx}$ besitzt.

Ist D gleich O, dann ergibt sich die Substratempfindlichkeit der Transistoren des Standes der Technik aus Gleichung 19:

$$\frac{dV_T}{dV_{sx}} = \frac{\epsilon_O \epsilon_s}{C_{ox}\sqrt{\frac{2\epsilon_O \epsilon_s}{qN_a}(V_{sx} + 2\phi)}} \qquad (19)$$

Vergleicht man Gleichungen 18 und 19, so sieht man sofort die wesentliche Verbesserung der Substratempfindlichkeit gemäß Gleichung 18, die sich aus der Anwesenheit des Ausdrucks

$$\left( \left[ X_1 + X_2 \right] \frac{D}{N_a} \right)$$

für die tiefe Ionen-Implantation ergibt.

Zur weiteren Erläuterung zeigt Fig. 3 eine graphische Darstellung der Beziehung zwischen der Substratempfindlichkeit in Millivolt je Volt, die über der Implantationsdosierung für Phosphorionen und verschiedener Implantationsenergien im Bereich von 200 bis 1000 KeV aufgetragen ist, wobei $X_1$ von 85 nm bis 921.3 nm und $X_2$ von 295 nm bis 1358.8 nm reicht. Beim Entwurf wird man dabei die auf der Ordinate dargestellte Größe. "Substratempfindlichkeit" im Diagramm der Fig. 3 auswählen und eine waagerechte Linie ziehen, die eine oder mehrere der Kurven schneidet. Jede Kurve stellt dabei eine andere Ionen-Implantations-Energie für die durch den Kanalbereich hindurch zur Bildung der vergrabenen Isolierschicht 10 implantierten Phosphorionen dar. Entsprechend den zur Verfügung stehenden Energien der Ionen-Implantations-apparatur wird dann die richtige Kurve ausgewählt und man erhält dann die entsprechende Dosierung für die Phosphorionen aus dem dadurch gegebenen Wert auf der Abszisse.

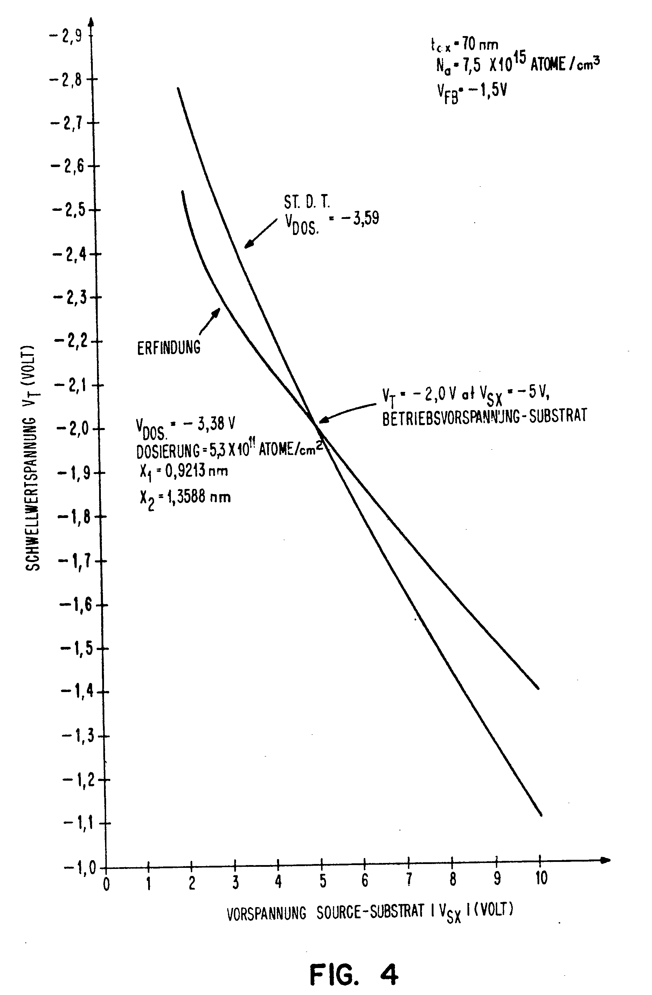

Als Beispiel wird eine mit einer Verarmungszone versehe Halbleiterstruktur gemäß der Erfindung mit einer Gate-Oxidschicht 7 einer Dicke tox von 70 nm gebildet, mit einer Hintergrunddotierungskonzentration $N_a$ von 7, $5 \times 10^{15}$ Atome/cm$^3$, einer Spannung $V_{FB}$ von $-$ 1,5 Volt, einer spannung Dosierung von $-3,38$ Volt und einer Implantationsdosierung von $5,3 \times 10^{11}$ Atome/cm$^2$ und einer Implantationsdicke für die obere Grenze $X_1$ der vergrabenen Isolierschicht von 920 nm und für die untere Grenze $X_2$ von 1358 nm. Das Diagramm der sich ergebenden Schwellenwergspannung als Funktion der Source-Substrat-Spannung wird mit der entsprechenden Schwellenwertspannung als Funktion der Source-Substrat-Spannung gemäß dem Stand der Technik in Fig. 4 verglichen. Man sieht, daß die erfindungsgemäß aufgebaute Struktur eine geringere Steigung oder eine geringere Änderungsgeschwindigkeit der Schwellenwertspannung in bezug auf die Source-Substrat-Spannung aufweist, wodurch gezeigt wird, daß bei vorgegebenen Veränderungen der Größe der Source-Substrat-Spannung sich geringere Änderungen der Schwellenwertspannung für eine gemäß der Erfindung aufgebaute Vorrichtung ergeben.

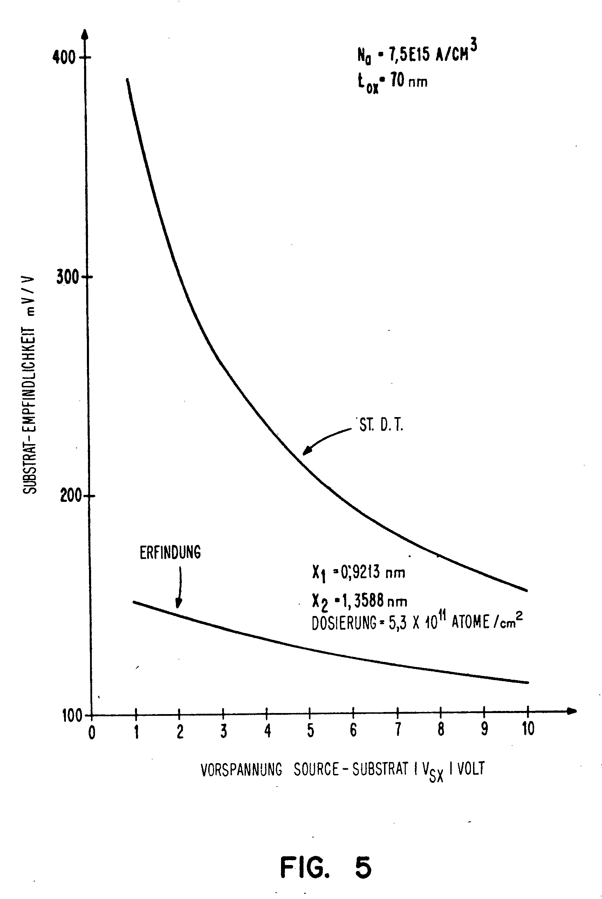

Fig. 5 zeigt die Substratempfindlichkeit in Millivolt je Volt als Funktion der Source-Substrat-Spannung für die verbesserte Halbleitervorrichtung mit den oben erwähnten Parametern im Vergleich mit einer Halbleitervorrichtung gemäß dem Stande der Technik. Man sieht, daß bei einer erfindungsgemäß aufgebauten Halbleiterstruktur sich eine ganz wesentliche Verringerung der Substratempfindlichkeit ergibt, verglichen mit dem Stande der Technik.

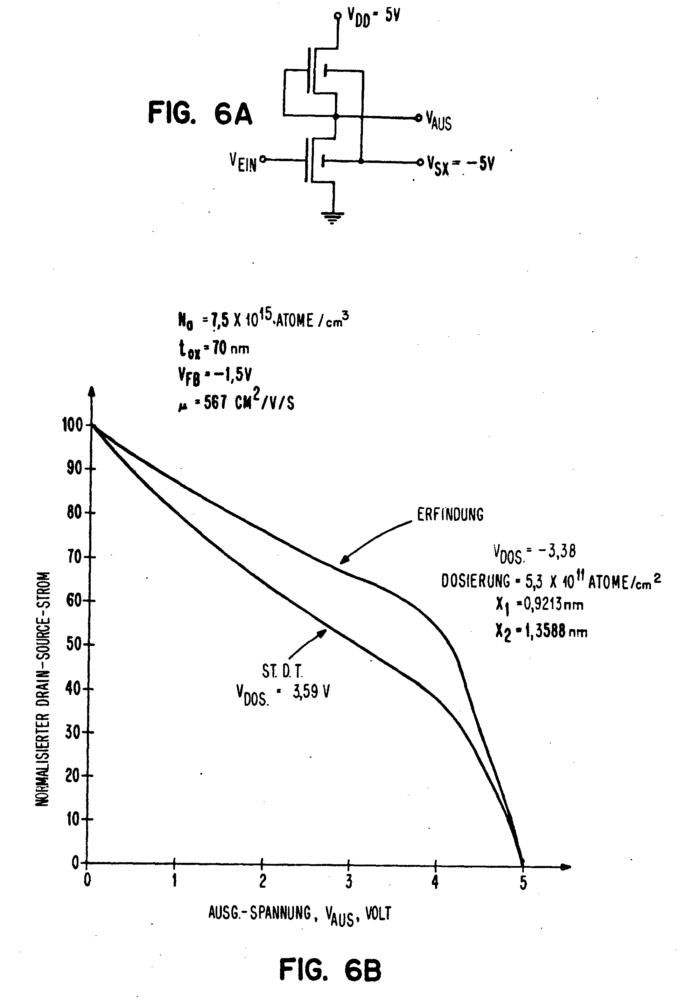

Eine einfache MOSFET-Inverterstufe kann gemäß Fign. 6A und 6B mit einem mit Eigenvorspannung arbeitenden MOSFET vom Verarmungstyp als Last und einem aktiven MOSFET vom Anreicherungstyp hergestellt werden, indem man die erfindungsgemäß aufgebaute Halbleiterstruktur für den erfindungsgemäß aufgebaute Halbleiterstruktur für den Lasttransistor benutzt, wodurch man eine wesentlich höhere Stromsteuerung des von Drain nach Source fließenden Stromes während des Umschaltvorgangs erhält, verglichen mit dem Stande der Technik in Fig. 6B.

Obgleich das bevorzugte Verfahren zum Einführen der Isolierschicht durch Ionen-Implantation dargestellt wurde, läßt sich die Erfindung auch durch andere Verfahren bei der Bildung einer vergrabenen Isolationsschicht zwischen Source und Drain durchführen. Beispielsweise könnte eine mehrschichtige Silicium-Epitaxie-Isolatorschicht-Struktur zur Bildung des Kanalbereichs eines Feldeffekttransistors gemäß der Erfindung verwendet werden.

Es ist bekannt, daß das Konzentrationsprofil der implantierten Isolierschicht 10 durch eine Anzahl von Ionen-Implantationsstufen besonders geformt werden kann, um ein optimales Profil zu erzielen.

## Patentansprüche

1. Isolierschicht-Feldeffekttransistor mit einem zwischen Source- (4) und Drainzone (6) eines ersten Leitungstyps gebildeten Kanal (16) eines zweiten Leitungstyps in einem Substrat (2) des zweiten Leitungstyps und einer über dem Kanal liegenden isolierten Gate-Elektrode, dadurch gekennzeichnte, daß in dem Substrat (2) unterhalb des Kanals (16) zwischen Source- (4) und Drainzone (6) eine vergrabene Isolierschicht (10) vorgesehen ist, die die im Falle eines durch Anlegen einer kritischen Substrat-Source-Vorspannung $V_{xsc}$ vollständig verarmten Kanals (16) vorhandene effektive Verarmungszone des Transistors tiefer in das Substrat (2) hinein ausdehnt, so daß der Abstand zwischen den elektrostatischen Ladungen auf der Gate-Elektrode und den von ihnen im Substrat (2) induzierten Ladungen derart erhölt ist, daß die Empfindlichkeit der Schwellenwertspannung $V_T$ gegenüber Änderungen der Substrate-Source-Vorspannung $V_{xs}$ verringert ist.

2. Isolierschicht-Feldeffekttransistor nach Anspruch 1, dadurch gekennzeichnet, daß die Isolierschicht eine dotierte Isolierschicht (10) des ersten Leitungstyps ist, bei der sich die Verarmungszonen des von der Isolierschicht (10) mit dem Substrate (2) gebildeten unteren und des von der Isolierschicht (10) mit dem Kanal (16) gebildeten oberen P—N-Übergangs etwa in der Mitte der Isolierschicht (10) miteinander vereinigen und somit ein zusammenhängendes verarmtes Gebiet bilden.

3. Isolierschicht-Feldeffekttransistor nach Anspruch 2, dadurch gekennzeichnet, daß die dotierte Isolierschicht (10) durch Ionenimplantation eines den ersten Leitungstyp hervorbringenden Dotierstoffs gebilet ist.

4. Isolierschicht-Feldeffekttransistor nach Anspruch 3, dadurch gekennzeichnet, daß die dotierte Isolierschicht (10) von einem Abstand $X_1$ unter der Oberfläche des Substrats (2) bis zu einem Abstand

$X_2$ unter der Oberfläche mit einer Ionenimplantations-Dosierung von D in einem Substrat mit einer Störelement-Konzentration von $N_a$-Atomen/cm$^3$ gebildet ist, so daß der fertige Transistor eine Substrat-Empfindlichkeit, d. h. ein Verhältnis der Änderung der Schwellenwertspannung $V_T$ zur Änderung der Substrat-Source-Vorspannung $V_{xs}$, von

$$dV \frac{dV_T}{sx}$$

aufweist, daß

$$dV \frac{dV_T}{sx}$$

gegeben ist durch die Beziehung

$$\frac{dV_T}{dV_{sx}} = \frac{\epsilon_O\,\epsilon_s}{C_{ox}\sqrt{\dfrac{2\,\epsilon_O\,\epsilon_s}{qN_a}\,(V_{sx} + 2\phi)} + (X_1 + X_2)\dfrac{D}{N_a}}$$

wobei:
$\varepsilon_o$  die Dielektrizitätskonstante des freien Raumes
$\varepsilon_s$  die Dielektrizitätskonstante des Substratmaterials
$C_{ox}$ die Gate-Isolierkapazität je Flächeneinheit
q  die Ladung das Elektrons und
$\phi$  das Fermi-Potential des Substratmaterials bedeuten.

5. Isolierschicht-Feldeffekttransistor nach den Ansprüchen 3 oder 4, dadurch gekennzeichnet, daß die dotierte Isolierschicht (10) durch mehrere Ionenimplantationen gebildet ist.

6. Isolierschicht-Feldeffekttransistor nach Anspruch 4, dadurch gekennzeichnet, daß der Kanal N-Leitung ist und daß vergrabene dotierte Isolierschicht (10) durch Implantation mit Phosphorionen gebildet ist.

7. Isolierschicht-Feldeffekttransistor nach Anspruch 4, dadurch gekennzeichnet, daß der Kanal P-leitend ist und daß die vergrabene dotierte Isolierschicht durch Implantation von Borionen gebildet ist.

8. Isolierschicht-Feldeffekttransistor nach Anspruch 4, dadurch gekennzeichnet, daß an der Oberfläche des Kanals (16) zur Bildung einer Verarmungszone eine zweite mit Ionen implantierte Schicht des ersten Leitungstyps gebildet ist, die bei N-leitendem Kanal mit Phosphorionen und bei P-leitendem Kanal mit Borionen implantiert ist.

**Revendications**

1. Transistor à effet de champ à couche isolante ayant une région de canal (16) d'un second type de conductivité formée entre la source (4) et le drain (6) d'un premier type de conductivitié, dans un substrat (2) du second type de conductivité, et un porte isolée sur la région de canal, caractérisé en ce que dans le substrat (2) sous la région de canal (16) entre la source (4) et le drain (6), se trouve enterrée une couche isolante (10) qui s'étale dans le substrat (2), la zone d;'appauvrissement effective du transistor apparaissant dans la région de canal (16) qui est complètement appauvrie par l'application d'une polarisation de substrat-source critique $V_{xsc}$, de sorte que la distance entre les charges électrostatiques sur la porte et les charges qu'elles induisent dans le substrat (2) augmente à un point tel qu'il y ait réduction de la sensibilité de la tension de seuil $V_T$ relative aux changements de la polarisation de substrat-source $V_{xs}$.

2. Transistor à effet de champ à couche isolante selon la revendication 1, caractérisé en ce que la couche isolante est une couch isolante dopée (10) du premier type de conductivité où les zones d'appauvrissement de la jonction PN inférieure formée par la couche isolante (10) avec le substrat (2), et de la jonction PN supérieure formée par la couche isolante (10) avec la région de canal (16), fusionnent approximativement au milieu de la couche isolante (10) pour former ainsi une région appauvrie continue.

3. Transistor à effet de champ à couche isolante selon la revendication 2, caractérisé en ce que la couche isolante dopée (10) est formée par implantation ionique d'un dopant produisant le premier type de conductivité.

4. Transistor à effet de champ à couche isolante selon la revendication 3, caractérisé en ce que la couche isolante dopée (10) est formée à une distance s'étendant de $X_1$ à $X_2$ sous la surface du substrat (2) avec un dosage d'implantation ionique D dans un substrat ayant une concentration d'impuretés de $N_a$-atomes/cm$^3$ de sorte que le transistor fini est un substrat dont la sensibilité, c'est-à-dire le rapport du changement de tension de seuil $V_T$ et du changement de polarisation de substrat-source $V_{xs}$,

# 0 000 883

$$\frac{dV_T}{dV_{sx}},$$

est donné par la relation

$$\frac{\partial V_T}{dV_{sx}} = \frac{\epsilon_s}{C_{ox}\sqrt{\frac{2\epsilon_0 \epsilon_s}{qN_a}(V_{sx} + 2\phi) + (X_1 + X_2)\frac{D}{N_a}}}$$

dans laquelle:

$\epsilon_0$ est la constante diélectrique de l'espace libre,

$\epsilon_s$ est la constante diélectrique du matériau du substrat,

$C_{ox}$ est la capacité d'isolement de la porte par unité de surface,

$q$ est la charge de l'électron, et

$\phi$ le potentiel de Fermi du matériau du substrat.

5. Transistor à effet de champ à couche isolante selon les revendications 3 ou 4, caractérisé en ce que la couche isolante dopée (10) est faite par plusieurs implantations ioniques.

6. Transistor à effet de champ à couche isolante selon la revendication 4, caractéisé en ce que la région de canal est de type de conductivité N, et en ce que la couche isolante dopée enterrée (10) est faite par implantation de ions phosphore.

7. Transistor à effet de champ à couche isolante selon la revendication 4, caractérisé en ce que la région de canal est de type de conductivité P, et en ce que la couche isolante dopée enterrée est faite par implantation de ions bore.

8. Transistor à effet de champ à couche isolante selon la revendication 4, caractérisé en ce que, pour former une zone d'appauvrissement, une seconde couche d'implantation ionique de premier type de conductivité est formée sur la surface du canal (16), cette couche étant implantée de ions phosphore lorsque le canal est de type de conductivité N, et de ions bore lorsque le canal est de type de conductivité P.

## Claims

1. Insulation layer field effect transistor with a channel region (16) of a second conductivity type formed between source (4) and drain (6) of a first conductivity type, in a substrate (2) of the second conductivity type and an insulated gate electrode over the channel region, characterised in that a buried insulation layer (10) is provided in the substrate (2) under the channel region (16) between source (4) and drain (6) which extends into the substrate (2) the effective transistor depletion zone appearing in connection with the channel region (16), which layer 10 can be completely depleted by the application of a critical substrate-source bias $V_{xsc}$, whereby the distance between the electrostatic charges on the gate electrode and the charges induced by them in the substrate (2) is increased to such an extent that the sensitivity of the threshold voltage $V_T$ relative to the changes of the substrate-source bias $V_{xs}$ is reduced.

2. Insulation layer field effect transistor as claimed in claim 1, characterised in that the insulation layer is a doped insulation layer (10) of the first conductivity type whereby the depletion zones of the lower PN junction formed between the insulation layer (10) and the substrate (2) and of the upper PN junction formed between the insulation layer (10) and the channel region (16) merge approximately in the middle of the insulation layer (10) and thus form a continuous depleted region.

3. Insulation layer field effect transistor as claimed in claim 2, characterised in that the doped insulation layer (10) is formed by ion implantation of a dopant producing the first conductivity type.

4. Insulation layer field effect transistor as claimed in claim 3, characterised in that the doped insulation layer (10) is formed from a distance $X_1$ under the surface of the substrate (2) to a distance $X_2$ under the surface with an ion implantation dosage of D in a substrate with an impurity concentration of $N_a$-atoms/-cm$^3$ so that the finished transistor shows a substrate sensitivity, i.e. a ratio of the change of threshold voltage $V_T$ to the change of substrate-source bias $V_{xs}$, of

$$\frac{dV_T}{dV_{sx}}$$

that

$$\frac{dV_T}{dV_{sx}}$$

is given by the relation

$$\frac{dV_T}{dV_{sx}} = \frac{}{C_{ox}\sqrt{\dfrac{2\,\epsilon_0\,\epsilon_s}{qN_a}\,(V_{sx} + 2\phi) + (X_1 + X_2)\dfrac{D}{N_a}}}$$

with the following factors applying:

$\epsilon_0$   the dielectric constant of the free space,
$\epsilon_s$   the dielectric constant of the substrate material
$C_{ox}$   the gate-insulation capacity per surface unit
$q$   the charge of the electron, and
$\phi$   the Fermi potential of the substrate material.

5. Insulation layer field effect transistor as claimed in claim 3 or 4, characterised in that the doped insulation layer (10) is made by several ion implantations.

6. Insulation layer field effect transistor as claimed in claim 6, characterised in that the channel region is N-conductive, and that the buried doped insulation layer (10) is made by phosphorus ion implantation.

7. Insulation layer field effect transistor as claimed in claim 4, characterised in that the channel region is P-conductive, and that the buried doped insulation layer is made by boron ion implantation.

8. Insulation layer field effect transistor as claimed in claim 4, characterised in that for forming a depletion zone a second ion-implanted layer of the first conductivity type is formed on the surface of the channel (16), that layer being implanted with phosphorus ions with N-conductive channel, and with boron ions with P-conductive channel.

0 000 883

SOURCE · X · GATE · DRAIN

FIG. 1A

FIG. 1B

N-DOTIERUNGS-
KONZENTRATION

ZONE 2 (N)

ZONE 1(P)

ZONE 3 (P)

$X_1$

$X_2$ $X_3$ $X_D$

0

KANAL-
OBERFLÄCHE

ABSTAND IM
SUBSTRAT, X

$X_S$ $X_{N1}$

$X_{N1}$

$V_{SXC}$

$V_I$

$V_D$

$V_{SX} \simeq V_{SXC} + V_1 + V_D$

P-DOTIERUNGS-
KONZENTRATION

FIG. 2

VERGR. KANAL-ZONE-
DOTIERUNG

| $X_1$(nm) | $X_2$(nm) | I/I ENERGIE, KEV |
|-----------|-----------|------------------|
| 85        | 285       | 200              |
| 190       | 450       | 300              |
| 290       | 590       | 400              |
| 401       | 739       | 500              |
| 509       | 871       | 600              |
| 616       | 1004      | 700              |
| 720       | 1120      | 800              |
| 824       | 1236      | 900              |
| 921       | 1359      | 1000             |

VERGR. KANAL-ZONE-
DOTIERUNG

SUBSTRAT-EMPFINDLICHKEIT mV/V

180
170
160
150
140
130
120
110
100
90
80
70
60
50
40
30
20
10
0

0 1 2 3 4 5 6 7 8

DOSIERUNG X $10^{11}$ ATOME /cm$^2$

$V_{SX}$ = —7,5V

$N_a$ = 7,5 X $10^{15}$ATOME/cm$^3$

$t_{ox}$ = 70nm

PHOSPHOR-
IONEN-IMPLANTAT

FIG. 3

FIG. 4

FIG. 5

**FIG. 6A**

$V_{DD}$ = 5V

$V_{AUS}$

$V_{EIN}$

$V_{SX}$ = −5V

$N_a$ = 7,5 X $10^{15}$ ATOME / $cm^3$

$t_{ox}$ = 70 nm

$V_{FB}$ = −1,5V

$\mu$ = 567 $CM^2$/V/S

ERFINDUNG

$V_{DOS.}$ = −3,38

DOSIERUNG = 5,3 X $10^{11}$ ATOME/$cm^2$

$X_1$ = 0,9213 nm

$X_2$ = 1,3588 nm

ST. D. T.

$V_{DOS.}$ = 3,59 V

NORMALISIERTER DRAIN-SOURCE-STROM

AUSG.-SPANNUNG, $V_{AUS}$, VOLT

**FIG. 6B**